# EUROPEAN PATENT APPLICATION

(11) **EP 4 564 406 A1**
(43) Date of publication of application: **04.06.2025**
(21) Application number: 24200259.0
(22) Date of filing: 13.09.2024
(51) Int. Cl.: H01L 21/48, H01L 23/498, H01L 23/538, H01L 23/14, H05K 3/46

(54) **SEMICONDUCTOR PACKAGE STRUCTURE**

(30) Priority: 29.11.2023 US 202363603681 P; 07.06.2024 US 202418736722
(71) Applicant: MediaTek Inc., 30078 Hsinchu City (TW)
(72) Inventor: SHEN, Yih-Ting, 30078 Hsinchu City (TW); CHEN, Yai-Yu, 30078 Hsinchu City (TW); LIN, Ping-Yeh, 30078 Hsinchu City (TW); LI, Yu-Jin, 30078 Hsinchu City (TW); CHANG, Chun-Yi, 30078 Hsinchu City (TW); CHEN, Chi-Yuan, 30078 Hsinchu City (TW); CHIU, Sang-Mao, 30078 Hsinchu City (TW)
(74) Representative: Haseltine Lake Kempner LLP

(57) **Abstract**

A semiconductor package structure includes a package substrate. The package substrate includes a first core structure, a plurality of first dielectric layers, a plurality of first metal layers, a plurality of second dielectric layers, and a plurality of second metal layers. The first core structure has a first surface and a second surface opposite the first surface. The first dielectric layers and the first metal layers are alternatingly stacked on the first surface of the first core structure. The second dielectric layers and the second metal layers are alternatingly stacked on the second surface of the first core structure. A number of second dielectric layers is less than a number of first dielectric layers.

## Description

This application claims the benefit of U.S. Provisional Application No. 63/603,681 filed on November 29, 2023, the entirety of which is incorporated by reference herein.

### BACKGROUND OF THE INVENTION

### Field of the Invention

The present invention relates to semiconductor technology, and, in particular, to a semiconductor package structure including a package substrate.

### Description of the Related Art

In addition to providing a semiconductor die with protection from environmental contaminants, a semiconductor package structure can also provide an electrical connection between the semiconductor die packaged inside it and a substrate such as a printed circuit board (PCB).

Although existing semiconductor package structures generally meet requirements, they have not been satisfactory in all respects. For example, because of request for high electrical signal performance, more and more metal layers in the package substrate are needed. However, as the size of the semiconductor package structure becomes larger and stack-up layers in the package substrate layer become more, the coefficient of thermal expansion (CTE) mismatch between the package substrate and the chip module would cause serious warpage, which results in a problem of low yield in surface mount technology (SMT). Therefore, further improvements in semiconductor package structures are required.

### BRIEF SUMMARY OF THE INVENTION

Semiconductor package structures are provided. An exemplary embodiment of a semiconductor package structure includes a package substrate. The package substrate includes a first core structure, a plurality of first dielectric layers, a plurality of first metal layers, a plurality of second dielectric layers, and a plurality of second metal layers. The first core structure has a first surface and a second surface opposite the first surface. The first dielectric layers and the first metal layers are alternatingly stacked on the first surface of the first core structure. The second dielectric layers and the second metal layers are alternatingly stacked on the second surface of the first core structure. A number of second dielectric layers is less than a number of first dielectric layers.

Another embodiment of a semiconductor package structure includes a package substrate. The package substrate includes a core structure, a plurality of first dielectric layers, a plurality of first metal layers, a plurality of second dielectric layers, and a plurality of second metal layers. The first dielectric layers and the first metal layers are alternatingly stacked below the core structure. The second dielectric layers and the second metal layers are alternatingly stacked over the core structure. A thickness of each of the second metal layers is different from a thickness of each of the first metal layers.

### BRIEF DESCRIPTION OF THE DRAWINGS

The present invention can be more fully understood by reading the subsequent detailed description and examples with references made to the accompanying drawings, wherein:
FIGs. 1 to 12 are cross-sectional views of exemplary package substrates in accordance with some embodiments of the present disclosure; and
FIGs. 13 to 16 are cross-sectional views of exemplary semiconductor package structures including a package substrate in accordance with some embodiments of the present disclosure.

### DETAILED DESCRIPTION OF THE INVENTION

The following description is made for the purpose of illustrating the general principles of the invention and should not be taken in a limiting sense. The scope of the invention is best determined by reference to the appended claims.

The present disclosure will be described with respect to particular embodiments and with reference to certain drawings, but the disclosure is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the disclosure.

Additional elements may be added on the basis of the embodiments described below. For example, the description of "a first element on/over a second element" may include embodiments in which the first element is in direct contact with the second element, and may also include embodiments in which additional elements are disposed between the first element and the second element such that the first element and the second element are not in direct contact.

The spatially relative descriptors of the first element and the second element may change as the structure is operated or used in different orientations. In addition, the present disclosure may repeat reference numerals and/or letters in the various embodiments. This repetition is for simplicity and clarity and does not in itself dictate a relationship between the various embodiments discussed.

A semiconductor package structure including a package substrate is described in accordance with some embodiments of the present disclosure. The package substrate includes different numbers of layers and/or different thicknesses of layers on opposite sides. As a result, the warpage issue can be mitigated without reducing the amount metal layers. In addition, the thickness of the core structure in the package substrate can be reduced to avoid affecting the electrical signal performance.

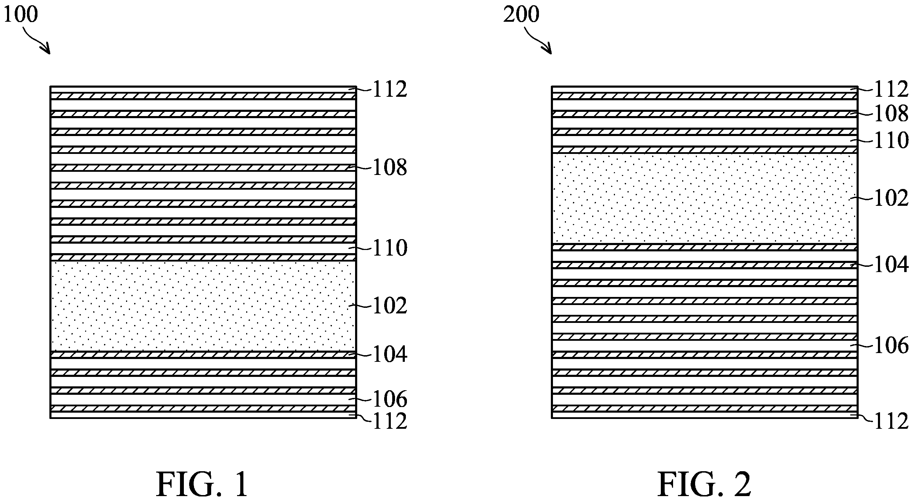

FIG. 1 is a cross-sectional view of a package substrate 100 in accordance with some embodiments of the present disclosure. Additional features can be added to the package substrate 100. Some of the features described below can be replaced or eliminated for different embodiments. To simplify the diagram, only a portion of the package substrate 100 is illustrated.

As illustrated in FIG. 1, a core structure 102 is provided, in accordance with some embodiments. The core structure 102 may be formed of an organic material, a glass material, a ceramic material, a semiconductor material, the like, or a combination thereof. The organic material may include fiberglass resin (e.g., FR4), bismaleimide triazine (BT) resin, the like, or a combination thereof. The semiconductor material may include silicon, germanium, or a compound material, including silicon germanium, silicon carbide, gallium arsenic, silicon germanium carbide, the like, or a combination thereof. One or more through vias (not illustrated) may be formed in the core structure 102.

A plurality of dielectric layers 106 and a plurality of metal layers 104 are alternatingly stacked below the core structure 102, and a plurality of dielectric layers 110 and a plurality of metal layers 108 are alternatingly stacked over the core structure 102, in accordance with some embodiments.

The dielectric layers 106 and 110 may be formed of dielectric material, including Ajinomoto build-up film (ABF) or another suitable material. The dielectric layers 106 and 110 may be formed by a lamination process, a coating process, or another suitable process. The metal layers 104 and 108 may be formed of copper, nickel, aluminum, tungsten, the like, an alloy thereof, or a combination thereof. The metal layers 104 and 108 may be formed by a plating process, an electroless plating process, or another suitable process.

As shown in FIG. 1, the number of metal layers 108 may be different from the number of metal layers 104, and the number of dielectric layers 110 may be different from the number of dielectric layers 106. Therefore, the package substrate 100 may be an unbalanced layer count substrate, so that the warpage issue can be mitigated. In addition, the thickness of the core structure 102 can be reduced. For example, the thickness of the core structure 102 may be in a range of about 200 µm to about 1400 µm, such as about 1240 µm.

The number of metal layers 108 may be greater than the number of metal layers 104, and the number of dielectric layers 110 may be greater than the number of dielectric layers 106. It should be noted that the numbers given for the metal layers 104 and 108 and the dielectric layers 106 and 110 are for illustrative purposes only, which may be more or fewer than shown in FIG. 1. In some embodiments, the ratio of the number of metal layers 108 to the number of metal layers 104 is in a range of 10 to 0.1, such as 2. In some embodiments, the ratio of the number of dielectric layers 110 to the number of dielectric layers 106 is in a range of 10 to 0.1, such as 2. If the ratio is greater than 10, the initial warpage of package substrate 100 may be too large and may cause cold-joint issue.

Protective layers 112 are disposed over the metal layers 108 and below the metal layers 104 to protect the surfaces of the metal layers 104 and 108, in accordance with some embodiments. The protective layers 112 may include a solder resist layer. The protective layers 112 may be formed of a resin material (such as a thermosetting resin, a photosensitive resin, or the like), an ink material, a tape material (such as a polyimide tape, a kapton tape, or the like), the like, or a combination thereof. The protective layers 112 may be formed by printing, coating, or another suitable methods.

FIG. 2 is a cross-sectional view of a package substrate 200 in accordance with some embodiments of the present disclosure. It should be noted that the package substrate 200 may include the same or similar components as those of the package substrate 100, which is illustrated in FIG. 1, and for the sake of simplicity, those components will not be discussed in detail again.

As shown in FIG. 2, the number of metal layers 104 may be greater than the number of metal layers 108, and the number of dielectric layers 106 may be greater than the number of dielectric layers 110. Therefore, the package substrate 200 may be an unbalanced layer count substrate, and the warpage can be alleviated. By adjusting the number of layers on different sides, such as arranged as the package substrate 100 of FIG. 1 or arranged as the package substrate 200 of FIG. 2, the warpage behavior of the package substrate can be controlled.

In some embodiments, the ratio of the number of metal layers 104 to the number of metal layers 108 is in a range of 10 to 0.1, such as 2. In some embodiments, the ratio of the number of dielectric layers 106 to the number of dielectric layers 110 is in a range of 10 to 0.1, such as 2. If the ratio is greater than 10, the initial warpage of package substrate 200 may be too large and may cause cold-joint issue.

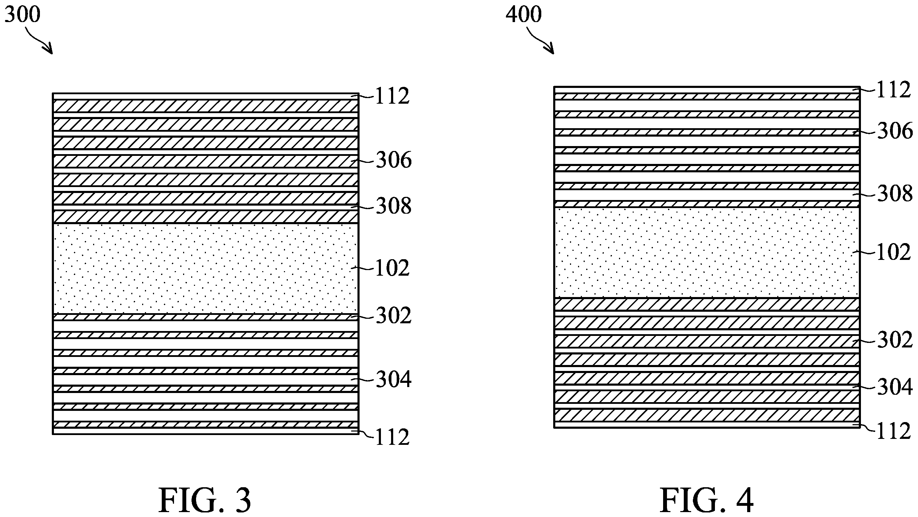

FIG. 3 is a cross-sectional view of a package substrate 300 in accordance with some embodiments of the present disclosure. It should be noted that the package substrate 300 may include the same or similar components as those of the package substrate 100, which is illustrated in FIG. 1, and for the sake of simplicity, those components will not be discussed in detail again. In the following embodiments, thicknesses of each of metal layers and/or thicknesses of each of dielectric layers are different on opposite sides of a core structure.

As shown in FIG. 3, a plurality of dielectric layers 304 and a plurality of metal layers 302 may be alternatingly stacked below the core structure 102, and a plurality of dielectric layers 308 and a plurality of metal layers 306 may be alternatingly stacked over the core structure 102. The thickness of each of the dielectric layers 304 may be different from the thickness of each of the dielectric layers 308. The thickness of each of the metal layers 302 may be different from the thickness of each of the metal layers 306. Therefore, the package substrate 300 may be an unbalanced layer thickness substrate, and the warpage can be mitigated.

The thickness of each of the dielectric layers 304 may be greater than the thickness of each of the dielectric layers 308. For example, the ratio of the thickness of one of the dielectric layers 304 to the thickness of one of the dielectric layers 308 may be in a range of about 1.05 to about 1.30, such as about 1.20. The thickness of each of the metal layers 306 may be greater than the thickness of each of the metal layers 302. For example, the ratio of the thickness of one of the metal layers 306 to the thickness of one of the metal layers 302 may be in a range of about 1.05 to about 1.30, such as about 1.20. If the ratio is greater than 1.30, the initial warpage of package substrate 300 may be too large and may cause cold joint issue.

Although both of the dielectric layers and the metal layers have different thicknesses, the present disclosure is not limited thereto. For example, the thickness of each of the dielectric layers 304 may be greater than the thicknesses of the dielectric layers 308, and the thickness of each of the metal layers 306 may be substantially equal to the thicknesses of the metal layers 302. In another example, the thickness of each of the metal layers 306 may be greater than the thickness of each of the metal layers 302, and the thickness of each of the dielectric layers 304 may be substantially equal to the thickness of each of the dielectric layers 308.

The total thickness of the metal layers 302 and the dielectric layers 304 may be different from the total thickness of the metal layers 306 and the dielectric layers 308. The total thickness of the metal layers 306 and the dielectric layers 308 may be greater than, substantially equal to, or less than the total thickness of the metal layers 302 and the dielectric layers 304.

As shown in FIG. 3, the number of metal layers 306 may be equal to the number of metal layers 302, and the number of dielectric layers 308 may be equal to the number of dielectric layers 304. The present disclosure is not limited thereto. The number of metal layers 306 may be greater than or less than the number of metal layers 302, and the number of dielectric layers 308 may be greater than or less than the number of dielectric layers 304, so that the warpage can be further alleviated.

In addition, it should be noted that the numbers given for the metal layers 302 and 306 and the dielectric layers 304 and 308 are for illustrative purposes only, which may be more or fewer than shown in FIG. 3.

FIG. 4 is a cross-sectional view of a package substrate 400 in accordance with some embodiments of the present disclosure. It should be noted that the package substrate 400 may include the same or similar components as those of the package substrate 300, which is illustrated in FIG. 3, and for the sake of simplicity, those components will not be discussed in detail again.

As shown in FIG. 4, the thickness of each of the dielectric layers 308 may be greater than the thickness of each of the dielectric layers 304. The thickness of each of the metal layers 302 may be greater than the thickness of each of the metal layers 306. Therefore, the package substrate 400 may be an unbalanced layer thickness substrate, and the warpage can be mitigated. The total thickness of the metal layers 302 and the dielectric layers 304 may be greater than, substantially equal to, or less than the total thickness of the metal layers 306 and the dielectric layers 308.

For example, the ratio of the thickness of one of the dielectric layers 308 to the thickness of one of the dielectric layers 304 may be in a range of about 1.05 to about 1.30, such as about 1.20. For example, the ratio of the thickness of one of the metal layers 302 to the thickness of one of the metal layers 306 may be in a range of about 1.05 to about 1.30, such as about 1.20. If the ratio is greater than 1.30, the initial warpage of package substrate 400 may be too large and may cause cold-joint issue.

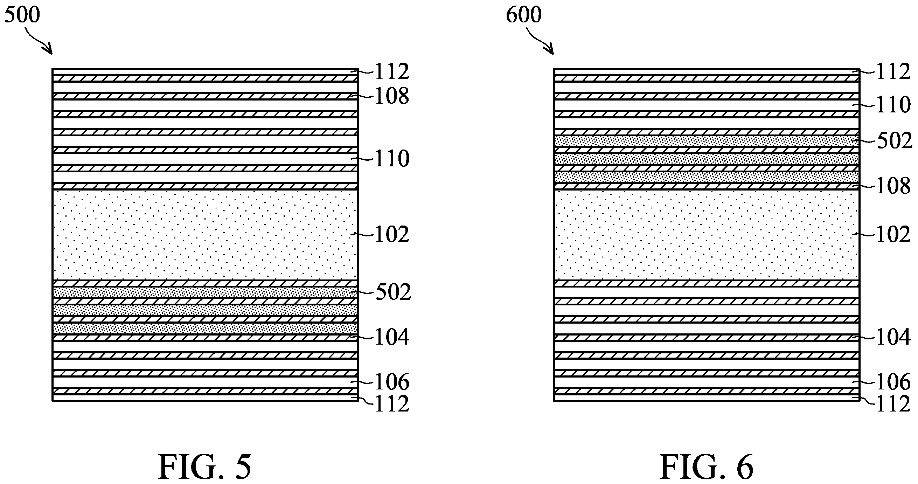

FIG. 5 is a cross-sectional view of a package substrate 500 in accordance with some embodiments of the present disclosure. It should be noted that the package substrate 500 may include the same or similar components as those of the package substrate 100, which is illustrated in FIG. 1, and for the sake of simplicity, those components will not be discussed in detail again. In the following embodiments, a plurality of prepreg layers are disposed adjacent to the core structure.

As shown in FIG. 5, a plurality of prepreg layers 502 are alternatingly stacked with some of the metal layers 104, in accordance with some embodiments. Therefore, the package substrate 500 may be an unbalanced multi-layer core substrate, and the warpage can be mitigated. The prepreg layers 502 may be formed of prepreg material, which may be a composite material made from pre-impregnated fibers (including silica filler, glass fiber, or the like) and polymer matrix (including epoxy, phenolic resin, or the like), such as FR4 epoxy resin, M6 epoxy resin, the like, or a combination thereof.

The prepreg layers 502 may be disposed below the core structure 102. That is, some of the dielectric layers 106 may be replaced by the prepreg layers 502. As a result, the coefficient of thermal expansion (CTE) mismatch can be reduced, which helps reduce warpage. In other words, the prepreg layers 502 may be alternatingly stacked with some of the metal layers 104 and may not be alternatingly stacked with the metal layers 108. Therefore, the number of dielectric layers 110 may be greater the number of dielectric layers 106.

The prepreg layers 502 may be disposed adjacent to the core structure 102 and away from the protective layer 112. In particular, the minimum distance between the core structure 102 and the dielectric layers 106 (i.e., the distance between the core structure 102 and the topmost dielectric layer 106) may be greater than the maximum distance between the core structure 102 and the prepreg layers 502 (i.e., the distance between the core structure 102 and the bottommost prepreg layer 502).

It should be noted that the numbers given for the prepreg layers 502, the metal layers 104, 108, and the dielectric layers 106, 110 are for illustrative purposes only, which may be more or fewer than shown in FIG. 5. For example, the number of metal layers 104 may be equal to the number of metal layers 108 as illustrated. In another example, the number of metal layers 108 may be greater than or less than the number of metal layers 104 to further mitigate the warpage. The number of prepreg layers 502 may be adjusted accordingly.

Moreover, the prepreg layers 502 may be disposed in the package substrate 300 of FIG. 3 or the package substrate 400 of FIG. 4, respectively. In particular, some of the dielectric layers 304 or 308 may be replaced by the prepreg layers 502. That is, the prepreg layers 502 may be alternatingly stacked with some of the metal layers 302 or 306. Therefore, the warpage can be further alleviated.

FIG. 6 is a cross-sectional view of a package substrate 600 in accordance with some embodiments of the present disclosure. It should be noted that the package substrate 600 may include the same or similar components as those of the package substrate 500, which is illustrated in FIG. 5, and for the sake of simplicity, those components will not be discussed in detail again. In the following embodiments, a plurality of prepreg layers are disposed over a core structure.

As shown in FIG. 6, the prepreg layers 502 are alternatingly stacked with some of the metal layers 108, in accordance with some embodiments. Therefore, the package substrate 600 may be an unbalanced multi-layer core substrate, and the warpage can be mitigated. The shape of the package substrate 600 can be adjusted (such as concave or convex) by changing the position of the prepreg layers 502. The prepreg layers 502 may be disposed over the core structure 102. In particular, some of the dielectric layers 110 may be replaced by the prepreg layers 502. That is, the prepreg layers 502 may be alternatingly stacked with some of the metal layers 108 and may not be alternatingly stacked with the metal layers 104.

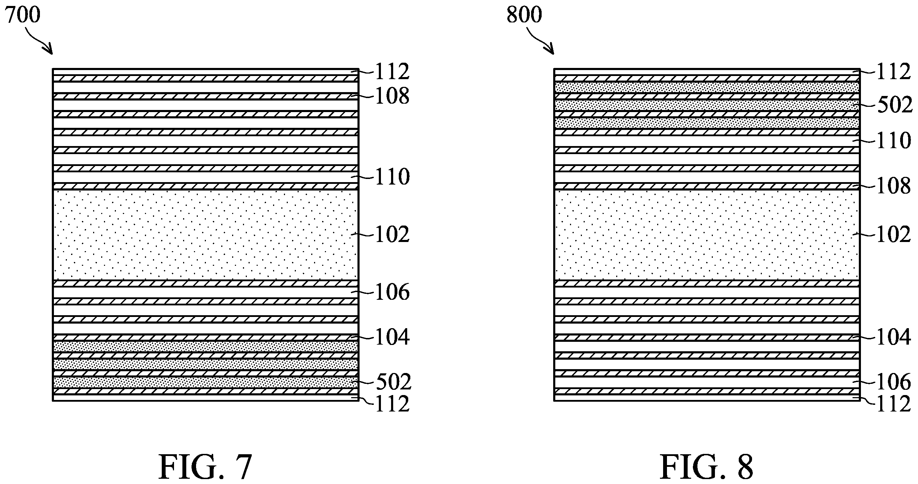

FIG. 7 is a cross-sectional view of a package substrate 700 in accordance with some embodiments of the present disclosure. It should be noted that the package substrate 700 may include the same or similar components as those of the package substrate 500, which is illustrated in FIG. 5, and for the sake of simplicity, those components will not be discussed in detail again. In the following embodiments, a plurality of prepreg layers are disposed away from a core structure.

As shown in FIG. 7, the prepreg layers 502 are alternatingly stacked with some of the metal layers 104, in accordance with some embodiments. Therefore, the package substrate 700 may be an unbalanced multi-layer core substrate, and the warpage can be mitigated. The prepreg layers 502 may be disposed adjacent to the protective layer 112 and away from the core structure 102. Since the prepreg layers 502 have coefficient of thermal expansion (CTE) lower than regular metal layers, as the distance of the prepreg layers 502 from the center increases, the warpage can be reduced further. When the prepreg layers 502 are farther away from the bonding interface, it would be more effective to adjust overall CTE of the package substrate 700 and thus to reduce substrate-component CTE mismatch.

In particular, the maximum distance between the core structure 102 and the dielectric layers 106 (i.e., the distance between the core structure 102 and the bottommost dielectric layer 106) may be less than the minimum distance between the core structure 102 and the prepreg layers 502 (i.e., the distance between the core structure 102 and the topmost prepreg layer 502).

It should be noted that the numbers given for the prepreg layers 502, the metal layers 104 and 108 and the dielectric layers 106 and 110 are for illustrative purposes only, which may be more or fewer than shown in FIG. 7. For example, the number of metal layers 104 may be equal to the number of metal layers 108 as illustrated. In another example, the number of metal layers 108 may be greater than or less than the number of metal layers 104 to further mitigate the warpage issue. The number of prepreg layers 502 may be adjusted accordingly.

FIG. 8 is a cross-sectional view of a package substrate 800 in accordance with some embodiments of the present disclosure. It should be noted that the package substrate 800 may include the same or similar components as those of the package substrate 700, which is illustrated in FIG. 7, and for the sake of simplicity, those components will not be discussed in detail again. In the following embodiments, a plurality of prepreg layers are disposed over a core structure.

As shown in FIG. 8, the prepreg layers 502 are alternatingly stacked with some of the metal layers 108, in accordance with some embodiments. Therefore, the package substrate 800 may be an unbalanced multi-layer core substrate, and the warpage can be mitigated. The prepreg layers 502 may be disposed over the core structure 102. In particular, some of the dielectric layers 110 may be replaced by the prepreg layers 502. That is, the prepreg layers 502 may be alternatingly stacked with some of the metal layers 108 and may not be alternatingly stacked with the metal layers 104.

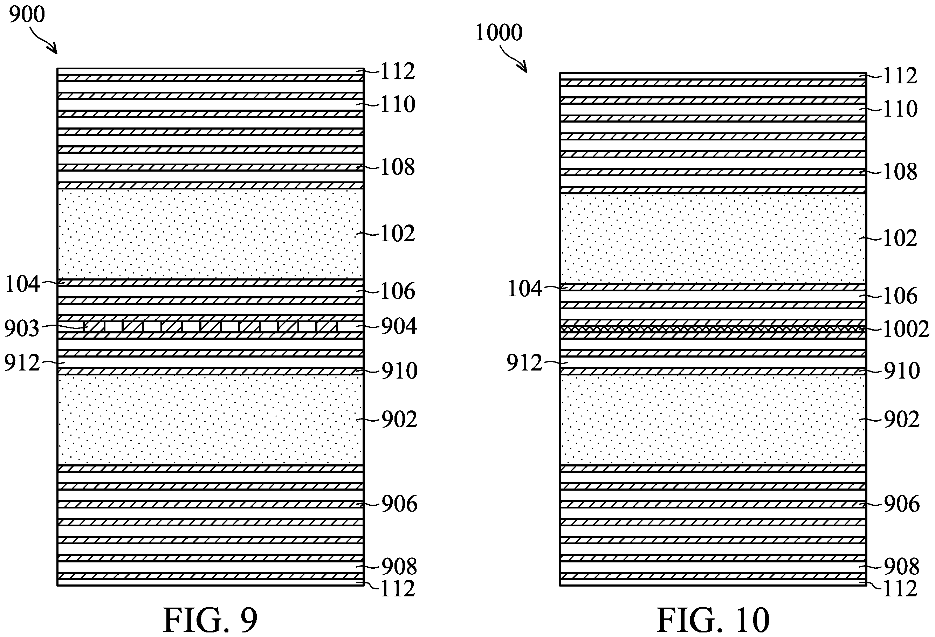

FIG. 9 is a cross-sectional view of a package substrate 900 in accordance with some embodiments of the present disclosure. It should be noted that the package substrate 900 may include the same or similar components as those of the package substrate 100, which is illustrated in FIG. 1, and for the sake of simplicity, those components will not be discussed in detail again. In the following embodiments, two core structures are stacked vertically.

As shown in FIG. 9, core structures 102 and 902 are provided, in accordance with some embodiments. The core structure 902 may be similar to the core structure 102, and will not be repeated. By stacking two core structures, the thickness of each of the core structure 102 and 902 can be reduced. In some embodiments, the thickness of the core structure 902 is in a range of about 200 µm to about 1400 µm, such as about 1240 µm. In some embodiments, the thickness of the core structure 102 is in a range of about 200 µm to about 1400 µm, such as about 1240 µm. The thickness of the core structure 902 may be the same as or different from the thickness of the core structure 102. Since the multi-core substrate has more layers compared to the single core substrate, the overall CTE will be lower and the CTE mismatch between the package substrate 900 and chip-on-wafer (CoW) components formed thereon can be reduced.

A plurality of dielectric layers 106 and a plurality of metal layers 104 may be alternatingly stacked below the core structure 102, and a plurality of dielectric layers 110 and a plurality of metal layers 108 may be alternatingly stacked over the core structure 102. Similarly, a plurality of dielectric layers 908 and a plurality of metal layers 906 may be alternatingly stacked below the core structure 902, and a plurality of dielectric layers 912 and a plurality of metal layers 910 may be alternatingly stacked over the core structure 902. The dielectric layers 908 and 912 may be similar to the dielectric layers 106 and 110, the metal layers 906 and 910 may be similar to the metal layers 104 and 108, and will not be repeated.

The number of metal layers 906 may be different from the number of metal layers 910, and the number of dielectric layers 908 may be different from the number of dielectric layers 912. For example, the number of metal layers 906 may be greater than the number of metal layers 910, and the number of dielectric layers 908 may be greater than the number of dielectric layers 912, as illustrated.

The core structures 102 and 902 may be stacked vertically by bonding the topmost metal layer 910 and the bottommost metal layer 104. Consequently, the process yield of the package substrate 900 can be improved. For example, a plurality of bump structures 903 may be formed on the topmost metal layer 910 and/or the bottommost metal layer 104. The bump structures 903 may include microbumps such as copper pillar bumps, controlled collapse chip connection (C4) bumps, solder balls, ball grid array (BGA) balls, the like, or a combination thereof.

The bump structures 903 may be formed of metal, such as tungsten, titanium, tantalum, ruthenium, cobalt, copper, aluminum, platinum, tin, silver, gold, the like, an alloy thereof, or a combination thereof. In some embodiments, the bump structures 903 may be formed of the material similar to that of the metal layer 910 or that of the metal layer 104. In such embodiments, conductor-to-conductor bonding, which may be metal-to-metal direct bonding, such as copper-to-copper direct bonding, may be adopted to connect the bump structures 903.

An underfill material 904 is formed between the topmost metal layer 910 and the bottommost metal layer 104, in accordance with some embodiments as illustrated in FIG. 9. The underfill material 904 may surround each of the bump structures 903 and may fill in gaps between the bump structures 903 to provide structural support. In some embodiments, the underfill material 904 includes polymer, such as epoxy. The underfill material 904 may be dispensed with capillary force, and then may be cured through any suitable curing process.

The number of metal layers 906 may be different from the total number of metal layers 104 and 910, and the number of dielectric layers 908 may be different from the total number of dielectric layers 106 and 912. In addition, the number of metal layers 108 may be different from the total number of metal layers 104 and 910, and the number of dielectric layers 110 may be different from the total number of dielectric layers 106 and 912. Therefore, the package substrate 900 is a copper-layer-to-copper-layer-connected multi-pieces substrate, so that the warpage can be mitigated.

As shown in FIG. 9, in some embodiments, the number of metal layers 906 is greater than the total number of metal layers 104 and 910, and the number of dielectric layers 908 is greater than the total number of dielectric layers 106 and 912. In these embodiments, the number of metal layers 108 is greater than the total number of metal layers 104 and 910, and the number of dielectric layers 110 is greater than the total number of dielectric layers 106 and 912.

However, the present disclosure is not limited thereto. In some other embodiments, the total number of metal layers 104 and 910 is greater than the number of metal layers 906, and the total number of dielectric layers 106 and 912 is greater than the number of dielectric layers 908. In these embodiments, the total number of metal layers 104 and 910 is greater than the number of metal layers 108, and the total number of dielectric layers 106 and 912 is greater than the number of dielectric layers 110. Other arrangements may be adopted.

Then, protective layers 112 may disposed over the metal layers 108 and below the metal layers 906 to protect the surfaces of the metal layers 108 and 906.

Although the thicknesses of the metal layers 104, 108, 906 and 910 are substantially the same, and the thicknesses of the dielectric layers 106, 110, 908 and 912 are substantially the same as illustrated, the present disclosure is not limited thereto. The thicknesses of the metal layers 104, 108, 906 and 910 may be different, and the thicknesses of the dielectric layers 106, 110, 908 and 912 may be different to further alleviate the warpage.

Furthermore, although the number of metal layers 108 and 906 are the same, and the number of dielectric layers 110 and 908 are the same as illustrated, the present disclosure is not limited thereto. The number of metal layers 108 and 906 may be different, and the number of dielectric layers 110 and 908 may be different to further mitigate the warpage.

Moreover, a plurality of prepreg layers (such as the prepreg layers 502 in FIG. 5) may be alternatingly stacked with some of the metal layers 104, 108, 906 and 910 to replace some of the dielectric layers 106, 110, 908 and 912 to further mitigate the warpage. The prepreg layers may be disposed adjacent to the core structure 102 and/or the core structure 902, or adjacent to one or both of the protective layers 112, such as those discussed in FIGs. 5 to 8.

FIG. 10 is a cross-sectional view of a package substrate 1000 in accordance with some embodiments of the present disclosure. It should be noted that the package substrate 1000 may include the same or similar components as those of the package substrate 900, which is illustrated in FIG. 9, and for the sake of simplicity, those components will not be discussed in detail again. In the following embodiments, metal layers are bonded through a solder layer.

As shown in FIG. 10, a solder layer 1002 is formed between the topmost metal layer 910 and the bottommost metal layer 104, in accordance with some embodiments. The solder layer 1002 may be formed by forming solder balls (not illustrated) on the topmost metal layer 910 and the bottommost metal layer 104. Then, a reflow process or another suitable process may be performed to form the solder layer 1002 and to connect the metal layers 910 and 104. Any other suitable connection method may be adopted.

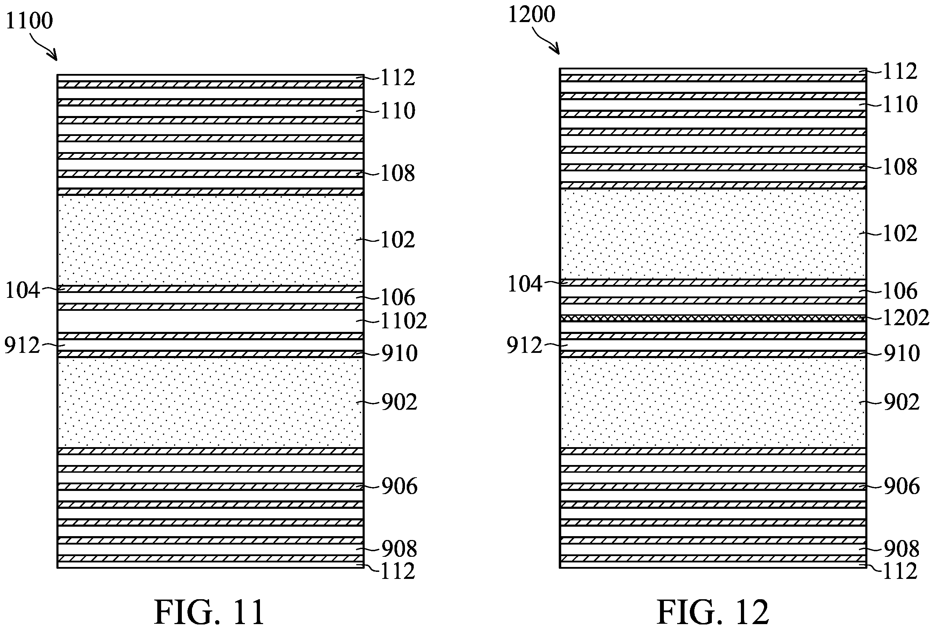

FIG. 11 is a cross-sectional view of a package substrate 1100 in accordance with some embodiments of the present disclosure. It should be noted that the package substrate 1100 may include the same or similar components as those of the package substrate 900, which is illustrated in FIG. 9, and for the sake of simplicity, those components will not be discussed in detail again. In the following embodiments, core structures are stacked vertically by bonding dielectric layers.

As shown in FIG. 11, the core structures 102 and 902 may be stacked vertically by bonding the topmost dielectric layer 912 and the bottommost dielectric layer 106. The dielectric layer 912 and the dielectric layer 106 may be bonded through dielectric-to-dielectric bonding, and then a bonded dielectric layer 1102 may be formed. The bonded metal layer 1102 may be formed of the topmost dielectric layer 912 and the bottommost dielectric layer 106, and may have a thickness that is greater than the thickness of one of the dielectric layers 912 and the thickness of one of the dielectric layers 106.

The number of metal layers 906 may be greater than the total number of metal layers 104 and 910, and the number of dielectric layers 908 may be greater than the total number of dielectric layers 106 and 912. The number of metal layers 108 may be greater than the total number of metal layers 104 and 910, and the number of dielectric layers 110 may be greater than the total number of dielectric layers 106 and 912. Therefore, the package substrate 1100 is a buildup-layer-to-buildup-layer-connected multi-pieces substrate, so that the warpage can be mitigated.

FIG. 12 is a cross-sectional view of a package substrate 1200 in accordance with some embodiments of the present disclosure. It should be noted that the package substrate 1200 may include the same or similar components as those of the package substrate 1100, which is illustrated in FIG. 11, and for the sake of simplicity, those components will not be discussed in detail again. In the following embodiments, dielectric layers are bonded through an adhesive layer.

As shown in FIG. 12, an adhesive layer 1202 is formed between the topmost dielectric layer 912 and the bottommost dielectric layer 106, in accordance with some embodiments. The adhesive layer 1202 may be formed on the topmost dielectric layer 912, on the bottommost dielectric layer 106, or on both of the topmost dielectric layer 912 and the bottommost dielectric layer 106 before bonding. Any other suitable connection method may be adopted.

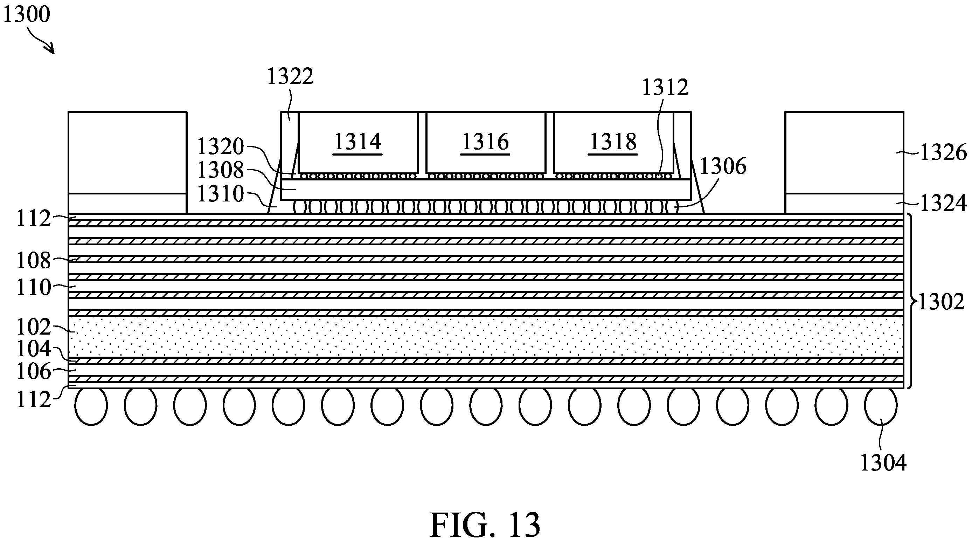

Exemplary semiconductor package structures include some of the package substrates illustrated in FIGs. 1 to 12 will be discussed below with reference to FIGs. 13 to 16.

FIG. 13 is a cross-sectional view of a semiconductor package structure 1300 in accordance with some embodiments of the present disclosure. Additional features can be added to the semiconductor package structure 1300. Some of the features described below can be replaced or eliminated for different embodiments. To simplify the diagram, only a portion of the semiconductor package structure 1300 is illustrated. The semiconductor package structure 1300 may include the same or similar components as those of the package substrate 100, which is illustrated in FIG. 1, and for the sake of simplicity, those components will not be discussed in detail again.

As shown in FIG. 13, the semiconductor package structure 1300 includes a package substrate 1302, in accordance with some embodiments. The package substrate 1302 may include a core structure 102, a plurality of dielectric layers 106 and 110 and a plurality of metal layers 104 and 108. The number of metal layers 108 may be different from the number of metal layers 104, and the number of dielectric layers 110 may be different from the number of dielectric layers 106. Therefore, the package substrate 1302 may be an unbalanced layer count substrate, so that the warpage can be mitigated.

The package substrate 1302 may be similar to the package substrate 100, which is illustrated in FIG. 1. That is, the number of metal layers 108 may be greater than the number of metal layers 104, and the number of dielectric layers 110 may be greater than the number of dielectric layers 106, as illustrated. Alternatively, the package substrate 1302 may be similar to the package substrate 200, which is illustrated in FIG. 2. That is, the number of metal layers 108 may be less than the number of metal layers 104, and the number of dielectric layers 110 may be less than the number of dielectric layers 106.

A plurality of conductive terminals 1304 may be disposed below the package substrate 1302. The conductive terminals 1304 may include microbumps, controlled collapse chip connection (C4) bumps, solder balls, ball grid array (BGA) balls, the like, or a combination thereof. The conductive terminals 1304 may be formed of metal, such as tungsten, titanium, tantalum, ruthenium, cobalt, copper, aluminum, platinum, tin, silver, gold, the like, an alloy thereof, or a combination thereof.

The semiconductor package structure 1300 includes an interposer 1308 disposed over the package substrate 1302, in accordance with some embodiments. The interposer 1302 may include a bulk semiconductor, a compound semiconductor, an alloy semiconductor, the like, or a combination thereof. The interposer 1302 may be formed of any suitable semiconductor material, such as silicon or germanium. The interposer 1308 may include a wiring structure (not illustrated).

The interposer 1308 may be electrically coupled to the package substrate 1302 through a plurality of bump structures 1306. The bump structures 1306 may include microbumps, controlled collapse chip connection (C4) bumps, solder balls, ball grid array (BGA) balls, the like, or a combination thereof. The bump structures 1306 may be formed of metal, such as tungsten, titanium, tantalum, ruthenium, cobalt, copper, aluminum, platinum, tin, silver, gold, the like, an alloy thereof, or a combination thereof.

Semiconductor dies 1314, 1316 and 1318 are disposed over the interposer 1308, in accordance with some embodiments. In some embodiments, the semiconductor dies 1314, 1316 and 1318 each independently includes a system-on-chip (SoC) die, a logic device, a memory device, a radio frequency (RF) device, the like, or a combination thereof. For example, the semiconductor dies 1314, 1316 and 1318 may each include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or a combination thereof.

The semiconductor dies 1314, 1316 and 1318 may include the same or different devices. The semiconductor package structure 1300 may include fewer or more semiconductor dies, and may also include one or more passive components disposed over the interposer 1308, such as resistors, capacitors, or inductors.

The semiconductor dies 1314, 1316 and 1318 may be electrically coupled to the interposer 1308 through a plurality of bump structures 1312. The bump structures 1312 may include microbumps, controlled collapse chip connection (C4) bumps, solder balls, ball grid array (BGA) balls, the like, or a combination thereof. The bump structures 1312 may include the materials discussed above with respect to the bump structures 1306 and will not be repeated.

An underfill material 1320 extends between the interposer 1308 and the semiconductor dies 1314, 1316 and 1318, in accordance with some embodiments. The underfill material 1320 may surround the bump structures 1312 and may fill in gaps between the bump structures 1312 to provide structural support. In some embodiments, the underfill material 1320 includes polymer, such as epoxy. The underfill material 1320 may be dispensed with capillary force, and then may be cured through any suitable curing process.

The semiconductor package structure 1300 includes a molding material 1322 disposed over the interposer 1308, in accordance with some embodiments. The molding material 1322 may surround the semiconductor dies 1314, 1316, 1318, the bump structures 1312, and the underfill material 1320 to protect these components from the environment, thereby preventing them from damage due to stress, chemicals, and moisture. The molding material 1322 may be formed of a nonconductive material, including moldable polymer, epoxy, resin, the like, or a combination thereof.

The sidewalls of the molding material 1322 may be substantially coplanar with the sidewalls of the interposer 1322. In some embodiments, the top surfaces of the semiconductor dies 1314, 1316, 1318 are exposed by the molding material 1322 as illustrated.

An underfill material 1310 may extend between the interposer 1308 and the package substrate 1302, in accordance with some embodiments. The underfill material 1310 may surround the bump structures 1306 and may fill in gaps between the bump structures 1306 to provide structural support. The underfill material 1310 may cover the sidewalls of the interposer 1308, and may partially cover the sidewalls of the molding material 1322. In some embodiments, the underfill material 1310 includes polymer, such as epoxy. The underfill material 1310 may be dispensed with capillary force, and then may be cured through any suitable curing process.

A frame 1326 is attached to the package substrate 1302 through an adhesive layer 1324, in accordance with some embodiments. The frame 1326 may be a ring structure. The frame 1326 may be disposed along the sidewalls of the package substrate 1302 to reduce warpage, prevent bending, and maintain planarity of the package substrate 1302. The frame 1326 may surround the interposer 1308 and the semiconductor dies 1314, 1316, 1318. The frame 1326 and the adhesive layer 1324 may be separated from the underfill layer 1310 by a gap. A portion of the top surface of the package substrate 1302 is thus exposed.

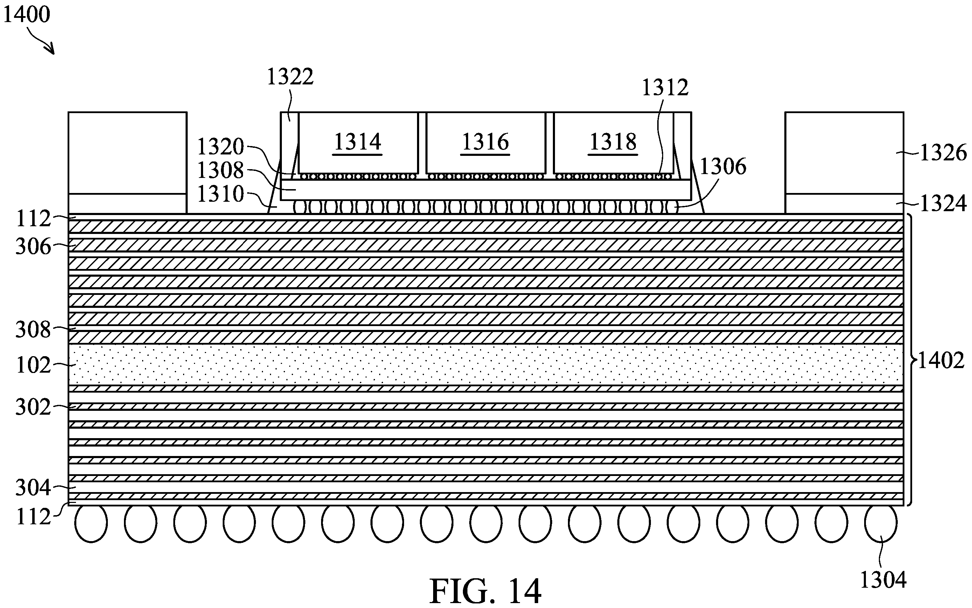

FIG. 14 is a cross-sectional view of a semiconductor package structure 1400 in accordance with some embodiments of the present disclosure. It should be noted that the semiconductor package structure 1400 may include the same or similar components as those of the semiconductor package structure 1300, which is illustrated in FIG. 13, and for the sake of simplicity, those components will not be discussed in detail again. In the following embodiments, thicknesses of metal layers and/or thicknesses of dielectric layers are different on opposite sides of a core structure.

As shown in FIG. 14, the semiconductor package structure 1400 includes a package substrate 1402, in accordance with some embodiments. The package substrate 1402 may include a core structure 102, a plurality of dielectric layers 304 and 308, and a plurality of metal layers 302 and 306. The thickness of each of the dielectric layers 304 may be different from the thickness of each of the dielectric layers 308. The thickness of each of the metal layers 302 may be different from the thickness of each of the metal layers 306. Therefore, the package substrate 1402 may be an unbalanced layer thickness substrate, so that the warpage can be mitigated.

The package substrate 1402 may be similar to the package substrate 300, which is illustrated in FIG. 3. That is, the thickness of each of the dielectric layers 304 may be greater than the thickness of each of the dielectric layers 308, and the thickness of each of the metal layers 306 may be greater than the thickness of each of the metal layers 302, as illustrated. Alternatively, the package substrate 1402 may be similar to the package substrate 400, which is illustrated in FIG. 4. That is, the thickness of each of the dielectric layers 308 may be greater than the thickness of each of the dielectric layers 304, and the thickness of each of the metal layers 302 may be greater than the thickness of each of the metal layers 306.

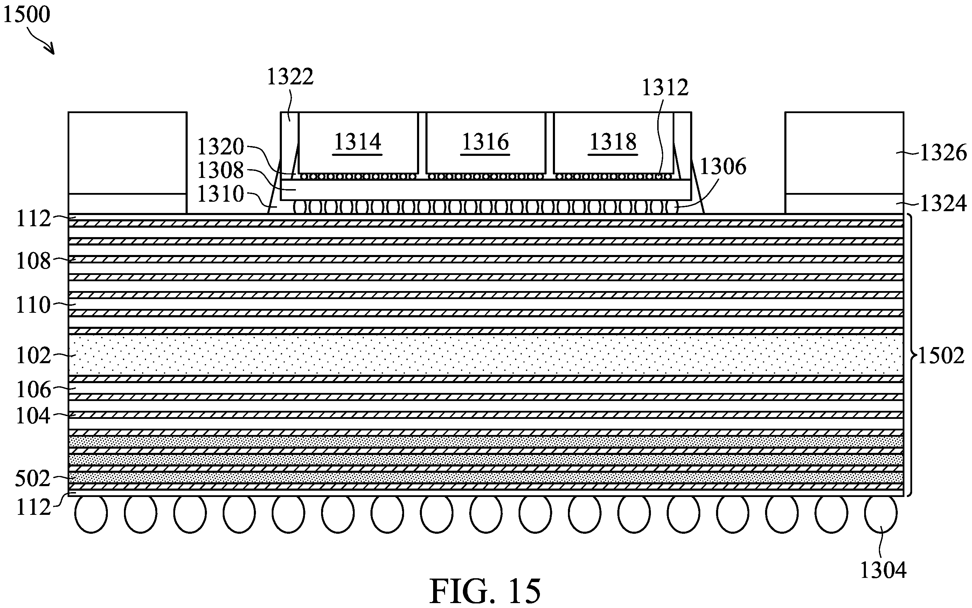

FIG. 15 is a cross-sectional view of a semiconductor package structure 1500 in accordance with some embodiments of the present disclosure. It should be noted that the semiconductor package structure 1500 may include the same or similar components as those of the semiconductor package structure 1300, which is illustrated in FIG. 13, and for the sake of simplicity, those components will not be discussed in detail again. In the following embodiments, a plurality of prepreg layers are alternatingly stacked with some of metal layers.

As shown in FIG. 15, the semiconductor package structure 1500 includes a package substrate 1502, in accordance with some embodiments. The package substrate 1502 may include a core structure 102, a plurality of dielectric layers 106 and 110, a plurality of metal layers 104 and 108, and a plurality of prepreg layers 502. The prepreg layers 502 may be alternatingly stacked with some of the metal layers 104. Therefore, the package substrate 1502 may be an unbalanced multi-layer core substrate, so that the warpage can be mitigated.

The package substrate 1502 may be similar to the package substrate 700, which is illustrated in FIG. 7. That is, the prepreg layers 502 may be alternatingly stacked with some of the metal layers 104 and may be disposed away from the core structure 102, as illustrated. Alternatively, the package substrate 1502 may be similar to the package substrate 500, which is illustrated in FIG. 5. That is, the prepreg layers 502 may be disposed adjacent to the core structure 102.

In another example, the package substrate 1502 may be similar to the package substrate 600, which is illustrated in FIG. 6. That is, the prepreg layers 502 may be alternatingly stacked with some of the metal layers 108 and may be disposed adjacent to the core structure 102. Alternatively, the package substrate 1502 may be similar to the package substrate 800, which is illustrated in FIG. 8. That is, the prepreg layers 502 may be alternatingly stacked with some of the metal layers 108 and may be disposed away from the core structure 102.

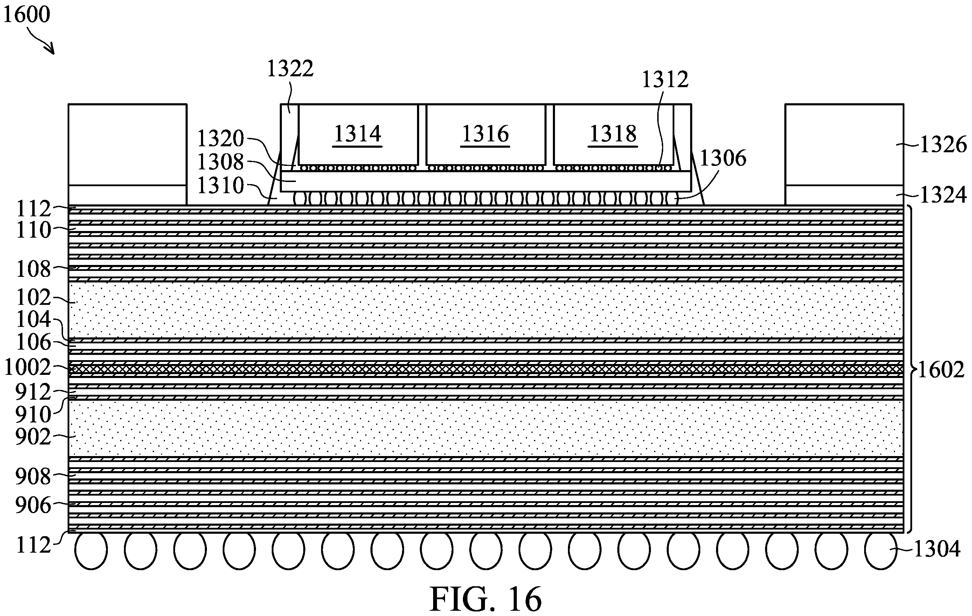

FIG. 16 is a cross-sectional view of a semiconductor package structure 1600 in accordance with some embodiments of the present disclosure. It should be noted that the semiconductor package structure 1600 may include the same or similar components as those of the semiconductor package structure 1300, which is illustrated in FIG. 13, and for the sake of simplicity, those components will not be discussed in detail again. In the following embodiments, two core structures are stacked vertically.

As shown in FIG. 16, the semiconductor package structure 1600 includes a package substrate 1602, in accordance with some embodiments. The package substrate 1602 may include core structures 102 and 902, a plurality of dielectric layers 106, 110, 908, 912, and a plurality of metal layers 104, 108, 906, 910. The number of metal layers 108 may be different from (such as greater than) the total number of metal layers 104 and 910, and the number of dielectric layers 110 may be different from (such as greater than) the total number of dielectric layers 106 and 912. The number of metal layers 906 may be different from (such as greater than) the total number of metal layers 104 and 910, and the number of dielectric layers 908 may be different from (such as greater than) the total number of dielectric layers 106 and 912. Therefore, the package substrate 1602 is a multi-pieces substrate, so that the warpage can be mitigated.

The package substrate 1602 may be similar to the package substrate 1000, which is illustrated in FIG. 10. That is, a solder layer 1002 may be adopted to bond the metal layers 104 and 910. Alternatively, the package substrate 1602 may be similar to the package substrate 900, which is illustrated in FIG. 9. That is, bump structures may be adopted to bond the metal layers 104 and 910.

In another example, the package substrate 1602 may be similar to the package substrate 1100, which is illustrated in FIG. 11. That is, a bonded dielectric layer including the dielectric layers 106 and 912 may be formed through dielectric-to-dielectric bonding. Alternatively, the package substrate 1602 may be similar to the package substrate 1200, which is illustrated in FIG. 12. That is, an adhesive layer may be adopted to bond the dielectric layers 106 and 912.

In summary, the semiconductor package structure according to the present disclosure includes a package substrate, which is an unbalanced substrate structure, an unbalanced layer thickness substrate, an unbalanced multi-layer core substrate, or a multi-pieces substrate. The package substrate includes different numbers of layers and/or different thicknesses of layers on opposite sides. As a result, the warpage issue can be mitigated without reducing the amount metal layers. In addition, the thickness of the core structure in the package substrate can be reduced to avoid affecting the electrical signal performance.

In some embodiments, the package substrate further includes prepreg layers to alleviate the warpage issue. The location of the prepreg layers may be adjusted to obtain the desired warpage behavior. In some embodiments, two substrates are stacked vertically to improve the process yield.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package structure (1300, 1400, 1500, 1600), comprising: a package substrate (100, 200, 300, 400, 500, 600, 700, 800, 900, 1000, 1100, 1200, 1302, 1402, 1502, 1602) comprising:
a first core structure (102) having a first surface and a second surface opposite the first surface;
a plurality of first dielectric layers (106) and a plurality of first metal layers (104) alternatingly stacked on the first surface of the first core structure (102); and
a plurality of second dielectric layers (110) and a plurality of second metal layers (108) alternatingly stacked on the second surface of the first core structure (102),
wherein a number of second dielectric layers (110) is less than a number of first dielectric layers (106).

2. The semiconductor package structure (1300, 1400, 1500, 1600) as claimed in claim 1, wherein the package substrate (500, 600, 700, 800) further comprises:
a plurality of prepreg layers (502) alternatingly stacked with some of the second metal layers (108).

3. The semiconductor package structure (1300, 1400, 1500, 1600) as claimed in claim 2, wherein a number of second metal layers (108) is equal to a number of first metal layers (104).

4. The semiconductor package structure (1300, 1400, 1500, 1600) as claimed in claim 2, wherein a minimum distance between the first core structure (102) and the second dielectric layers (110) is greater than a maximum distance between the first core structure (102) and the prepreg layers (502).

5. The semiconductor package structure (1300, 1400, 1500, 1600) as claimed in claim 2, wherein a maximum distance between the first core structure (102) and the second dielectric layers (110) is less than a minimum distance between the first core structure (102) and the prepreg layers (502).

6. The semiconductor package structure (1300, 1400, 1500, 1600) as claimed in claim 1, wherein a number of second metal layers (108) is less than a number of first metal layers (104).

7. The semiconductor package structure (1300, 1400, 1500, 1600) as claimed in claim 1, wherein the package substrate (900, 1100, 1602) further comprises:
a second core structure (902) having a third surface adjacent to the second metal layers (108) and a fourth surface opposite the third surface; and
a plurality of third dielectric layers (908, 912) and a plurality of third metal layers (906, 910) alternatingly stacked on the fourth surface of the second core structure (902).

8. The semiconductor package structure (1300, 1400, 1500, 1600) as claimed in claim 1, further comprising a plurality of bump structures (903) disposed between two of the second metal layers (108).

9. The semiconductor package structure (1300, 1400, 1500, 1600) as claimed in claim 1, wherein one of the second dielectric layers (110) is thicker than the other second dielectric layer (110).

10. The semiconductor package structure (1300, 1400, 1500, 1600) as claimed in claim 1, wherein the package substrate (1000, 1602) further comprises a solder layer (1002) disposed between two of the second metal layers (104, 910).

11. The semiconductor package structure (1300, 1400, 1500, 1600) as claimed in claim 1, wherein the package substrate (1200) further comprises an adhesive layer (1202) disposed between two of the second dielectric layers (106, 912).

12. The semiconductor package structure (1300, 1400, 1500, 1600) as claimed in claim 1, wherein a thickness of each of the second metal layers (306) is greater than a thickness of each of the first metal layers (302).

13. The semiconductor package structure (1300, 1400, 1500, 1600) as claimed in claim 12, wherein a ratio of the thickness of each of the second metal layers (306) to the thickness of each of the first metal layers (302) is in a range of about 1.05 to about 1.30.

14. The semiconductor package structure (1300, 1400, 1500, 1600) as claimed in claim 12, wherein a thickness of each of the second dielectric layers (308) is less than a thickness of each of the first dielectric layers (304).

15. The semiconductor package structure (1300, 1400, 1500, 1600) as claimed in claim 14, wherein a total thickness of the second metal layers (306) and the second dielectric layers (308) is different from a total thickness of the first metal layers (302) and the first dielectric layers (304).
